(19) Europäisches Patentamt
European Patent Office
Office européen des brevets

(11) Veröffentlichungsnummer : **0 388 483 B1**

(12) # EUROPÄISCHE PATENTSCHRIFT

(45) Veröffentlichungstag der Patentschrift : **30.11.94 Patentblatt 94/48**

(51) Int. Cl.$^5$ : **G03F 7/023**, G03F 7/30

(21) Anmeldenummer : **89104949.6**

(22) Anmeldetag : **20.03.89**

(54) **Verfahren zum Erzeugen einer Photoresiststruktur.**

(43) Veröffentlichungstag der Anmeldung : **26.09.90 Patentblatt 90/39**

(45) Bekanntmachung des Hinweises auf die Patenterteilung : **30.11.94 Patentblatt 94/48**

(84) Benannte Vertragsstaaten : **BE CH DE ES FR GB IT LI NL SE**

(56) Entgegenhaltungen :
**EP-A- 0 286 272**
**WO-A-89/07786**
**BE-A- 569 763**
**DE-A- 1 447 010**
**FR-A- 2 477 294**
**US-A- 2 990 281**
**US-A- 3 887 371**
**US-A- 4 720 445**
**IBM TECHNICAL DISCLOSURE BULLETIN, Band 23, Nr. 7B, Dezember 1980, Seite 3212,New York, US; L.H. KAPLAN et al.: "Single layer lift-off structures from E-beam-exposed resists"**

(73) Patentinhaber : **SIEMENS AKTIENGESELLSCHAFT**
**Wittelsbacherplatz 2**
**D-80333 München (DE)**

(72) Erfinder : **Sezi, Recai, Dr.Ing., Dipl.-Chem.**
**Weiherstrasse 14**
**D-8551 Röttenbach (DE)**
Erfinder : **Sebald, Michael, Dr. rer. nat., Dipl.-Chem.**
**Kirchensteig 3**
**D-8521 Hessdorf (DE)**
Erfinder : **Leuschner, Rainer, Dr. rer. nat., Dipl.-Chem.**
**Buchenweg 2**
**D-8521 Grossenseebach (DE)**
Erfinder : **Birkle, Siegfried, Dr. rer. nat., Dipl.-Chem.**
**Veit-Stoss-Strasse 46**
**D-8552 Höchstadt (DE)**
Erfinder : **Ahne, Hellmut, Dr. Ing., Dipl.-Chem.**
**Heideweg 7**
**D-8551 Röttenbach (DE)**

**EP 0 388 483 B1**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

Photoresists sind in der mikroelektronischen Industrie zur Darstellung von Halbleiterbausteinen, zum Beispiel von integrierten Schaltkreisen oder Speicherbausteinen, unabdingbar. Die Definition und Erzeugung von Strukturen auf Halbleiterbausteinen erfolgt auf photolithographischem Weg, wobei eine vorgegebene Struktur von einer Vorlage (Maske) mittels optischer Methoden auf ein Substrat, zum Beispiel einen Wafer, übertragen wird. Die Übertragung gelingt mit Hilfe einer Photoresistschicht, in der durch die Belichtung eine gezielte chemische Veränderung vorgenommen wird. Als deren Folge zeigen die belichteten Bereiche ein verändertes Löslichkeitsverhalten gegenüber einer Entwicklung, die üblicherweise naßchemisch vorgenommen wird.

Gängige Photoresists sind in ihrer Empfindlichkeit auf Licht der Wellenlänge von 436 nm bzw. 365 nm (NUV-Bereich) abgestimmt. In diesem Wellenlängenbereich können selbst mit höchstauflösenden Photoresistsystemen aufgrund physikalischer Gesetze nur Strukturen bis ca. 0,5 µm aufgelöst und somit erzeugt werden. Gemäß der Formel

$$CD = k\frac{\lambda}{NA}$$

ist die kleinste abgebildete Struktur CD proportional der Wellenlänge $\lambda$ des zur Lithographie benutzten Lichtes. NA ist die numerische Apertur und somit von dem optischen System abhängig, während k einen prozeßspezifischen Faktor darstellt. Da die Leistungsfähigkeit integrierter Schaltungen ständig durch weitere Erhöhung der Integrationsdichte gesteigert wird, müssen dazu auch Verfahren entwickelt werden, die das Erzeugen immer kleinerer Strukturen erlauben. Eine leistungsfähigere Photolithographie muß daher mit kürzerwelligem Licht arbeiten, zum Beispiel mit tiefem UV (= DUV), also im Bereich unterhalb von 300 nm.

Die leistungsfähigsten bekannten Photoresists für den NUV-Bereich sind positiv arbeitend und beruhen auf dem Lösungsinhibitorprinzip. Sie bestehen aus einem alkalilöslichen Basispolymeren und einer photoaktiven Komponente (PAC). Diese ist hydrophob und verhindert einen Angriff des zum Entwickeln verwendeten alkalischen Mediums. Erst bei Bestrahlung mit Licht geeigneter Wellenlänge wird die PAC in einem photochemischen Prozeß in eine hydrophile Verbindung umgewandelt. In den belichteten und somit hydrophil gewordenen Bereichen einer Photoresistschicht kann nun das Basispolymer vom Entwickler aufgelöst werden, wobei in der Photoresistschicht die gewünschte Struktur entsteht.

Eine wichtige Eigenschaft von Photoresistschichten ist es, daß sie "ausbleichen", das heißt, ihre Absorption für Licht der Bestrahlungswellenlänge während der Bestrahlung bis auf einen Grenzwert verringern. Dieser setzt sich zusammen aus der Restabsorption der umgewandelten PAC und aus der Absorption des Basispolymers. Je geringer diese Restabsorption ist, desto tiefer kann das Licht in die Resistschicht eindringen und desto höher ist das Auflösungsvermögen, der Kontrast und die Flankensteilheit der erzeugten Strukturen. Beim Übergang auf eine Bestrahlungswellenlänge im DUV-Bereich stellt diese Restabsorption das größte Problem dar, da sie mit abnehmender Wellenlänge für die meisten Resistmaterialien ansteigt. Es müssen daher völlig neue Resistmaterialien entwickelt werden.

Weitere Anforderungen an einen Photoresist ergeben sich aus den auf die Strukturierung des Resists folgenden Verfahrensstufen. Dabei dient die entwickelte Resiststruktur als Maske für die verschiedensten chemischen oder physikalischen Behandlungen des unter der Maske befindlichen Substrates. Möglich ist zum Beispiel ein Materialabtrag durch Ätzen, eine Materialabscheidung, chemische Behandlung wie Oxidieren oder physikalische Behandlung wie zum Beispiel Dotieren. Voraussetzung für diese Behandlung ist eine hohe chemische und thermische Stabilität der Resiststrukturen und damit letztlich des Basispolymers.

In der bisher beschriebenen sogenannten Einlagentechnik, bei der eine einzige Photoresistschicht direkt auf dem Substrat aufgebracht wird, werden bisher hauptsächlich Novolakharze als Basispolymere eingesetzt. Aufgrund ihres hohen Anteils an Aromaten in ihrer chemischen Struktur und aufgrund ihrer Fähigkeit zur Vernetzung bei thermischer oder photochemischer Behandlung erfüllen sie hinreichend die an Photoresists gestellten Anforderungen.

Bei der Photostrukturierung von Substraten, die eine stufenaufweisende oder aus reflektierendem Material bestehende Oberfläche besitzen, treten weitere Probleme auf. Eine unebene Substratoberfläche erfordert eine höhere Schichtdicke zum Ausgleichen der Unebenheiten. Da aber eine genaue Fokussierung bei der Belichtung nur bis zu einer bestimmten Tiefe innerhalb der Photoresistschicht möglich ist, und diese Fokustiefe beim Übergang auf kürzerwelliges Licht weiter abnimmt, wird bei der Einlagentechnik meist eine schlechtere Auflösung der Strukturen erzielt, welche durch Reflexionen an der Substratoberfläche oder an Substratstufen weiter abnimmt.

In der sogenannten Zweilagentechnik werden diese Probleme gelöst bzw. umgangen. Dabei wird auf dem Substrat zunächst eine optisch dichte, planarisierende erste Resistschicht aufgebracht und diese anschließend mit einer zweiten, dünnen photolithographisch strukturierbaren Resistschicht abgedeckt. Nachfolgend wird nun diese zweite Resistschicht strukturiert. Nach der Entwicklung dient die in der zweiten Resistschicht

entstandene Struktur als Maske zur Strukturierung der darunterliegenden ersten Resistschicht in einem anisotropen Ätzverfahren, zum Beispiel mit sauerstoffhaltigem Plasma. Die Maßhaltigkeit bei dieser Übertragung wird durch eine hohe Resistenz des zweiten Resists gegenüber dem Ätzverfahren gewährleistet. Eine solche wird durch den Einbau bestimmter Elemente erzielt, die zum Beispiel im Sauerstoffplasma nichtflüchtige Oxide bilden und so die Resiststruktur vor weiterem Ätzangriff schützen.

Ein idealer Photoresist soll nach Möglichkeit sowohl für Einlagen- als auch Zweilagentechnik zu verwenden sein. Bei der Belichtung soll er eine hohe Empfindlichkeit zeigen, eine gute Auflösung mit steilen Flankenwinkeln bei den erzeugten Strukturen bringen, gut ausbleichen, ein Basispolymer mit hoher Transparenz besitzen, eine hohe Plasmaätzresistenz aufweisen und außerdem mit gängigen alkalischen Entwicklern entwickelbar sein. Diese Anforderungen werden bislang von keinem bekannten Photoresist befriedigend erfüllt.

Unter Verwendung von Anhydriden lassen sich ätzresistente, lagerstabile, UV-transparente und temperaturstabile Polymere erhalten, die bezüglich dieser genannten Eigenschaften gut als Basispolymere für positiv arbeitende DUV-Resists geeignet sind, sich jedoch schlecht entwickeln lassen. Selbst mit den stärksten kommerziell erhältlichen alkalischen Entwicklern wird nur eine langsame und kontrastarme Entwicklung eines anhydridhaltigen Resists erreicht. Die Ahydrifdunktion ist auch in stark polarem Medium nur schlecht hydrolisierbar. So sind bisher bekannte anhydridhaltige Resists nur in Verbindung mit anderen lösungsvermittelnden bzw. entwickelbaren Gruppen eingesetzt worden.

Aus der älteren internationalen Anmeldung WO 89/07786 ist ein Resistsystem bekannt, welches neben einer photoaktiven Komponente ein anhydridgruppenhaltiges Copolymer aufweist. Zur Entwicklung des Resistsystems wird Tetramethylammoniumhydroxid verwendet.

Aus der französischen Patentanmeldung FR-A-2 477 294 ist ein Photoresistsystem bekannt, welches aus einem Copolymer einer photoaktiven Komponente besteht. Das Copolymer wird aus konjugierten Diolefinen, Monoolefinen und Alpha, Beta-ungesättigten Carbonsäuren gebildet, die auch durch Anhydride ersetzt sein können. Zur Entwicklung wird eine Reihe basischer organischer und anorganischer Verbindungen vorgeschlagen.

Aufgabe der vorliegenden Erfindung ist es daher, ein Verfahren zum Erzeugen einer kontrastreichen Photoresiststruktur anzugeben, das unter Verwendung eines anhydridhaltigen Resists eine Strukturierung im DUV-Bereich erlaubt und Strukturen im sub-μm-Bereich erzeugen kann.

Diese Aufgabe wird erfindungsgemäß durch ein Verfahren zum Erzeugen einer kontrastreichen Photoresiststruktur im sub-μm-Bereich mit steilen Flanken gelöst, bei dem

a) auf ein Substrat eine Photoresistschicht aufgebracht und gegebenenfalls getrocknet und vorvernetzt wird, wobei der Photoresist eine photoaktive Komponente und ein Basispolymer enthält, welches als entwickelbare funktionelle Gruppen Anhydridfunktionen aufweist,

b) die Photoresistschicht über eine Maske dergestalt strukturierend belichtet wird, daß in den belichteten Bereichen eine chemische Veränderung der photoaktiven Komponente erzielt wird, und

c) die strukturierend belichtete Photoresistschicht mit einer wäßrig-alkalischen Entwicklerlösung behandelt wird, wobei diese Entwicklerlösung ein Amin enthält, welches zumindest ein aktives, an den Stickstoff gebundenes Wasserstoffatom aufweist, und welches die Anhydridgruppen der Photoresistschicht in bestimmten, von der Belichtung abhängigen Bereichen zu hydrolisieren vermag.

Weitere Ausgestaltungen der Erfindung sind den Unteransprüchen zu entnehmen.

Mit dem erfindungsgemäßen Verfahren werden anhydridhaltige Polymere der Verwendung als Photoresist zugänglich gemacht, wobei die vorteilhaften Eigenschaften der Klasse der Anhydride auf die Eigenschaften des Photoresists und damit auf das Strukturierungsverfahren übertragen werden. Als Folge der hohen UV-Transparenz, der großen thermischen Formstabilität und der Ätzresistenz von anhydridhaltigen Polymeren wird mit diesem neuen Strukturierungsverfahren der DUV-Bereich für die Photolithographie erschlossen. Somit wird zumindest die theoretische Grenze für die maximale Auflösung herabgesetzt und Strukturierungen bis zu einer Strukturbreite von ca. 0,5 μm und darunter ermöglicht. Die hergestellten Strukturen sind kontrastreich und weisen steile Flanken auf. Aufgrund der thermischen und chemischen Eigenschaften der anhydridhaltigen Resists ist das Verfahren vielfach anwendbar, sowohl in der Einlagen- als auch in der Zweilagentechnik. Die so erzeugten Photoresiststrukturen können als Strukturierungshilfsmaske für viele weitere Schritte dienen, die eine hohe Temperaturstabilität und/oder eine Ätzresistenz erfordern. Das Verfahren ist somit gut in der Mikroelektronik zur Herstellung von höchstingegrierten Halbleiterbausteinen und -schaltungen geeignet, da es eine weitere Steigerung der Integrationsdichte gegenüber bekannten photolithographischen Verfahren erlaubt. Der hohe Kontrast der erzeugten Strukturen minimiert die Fehlerrate bei der optischen Strukturübertragung und führt somit zu weitgehend fehlerfreien Produkten.

Die erfindungsgemäße Verwendung eines Entwicklers, der die Anhydridfunktion zu hydrolisieren vermag, trägt in besonderem Ausmaß zur Steigerung des Kontrasts der erzeugten Strukturen bei. Während bei bekannten positiv arbeitenden Photoresists alkalilösliche Basispolymere verwendet werden, die lediglich durch

Beimischung der hydrophoben PAC der Lösung im alkalischen Entwickler entgehen, wird im erfindungsgemäßen Verfahren primär durch die Belichtung noch keine Löslichkeit des Basispolymers erzeugt. Erst im Entwicklungsvorgang wird die unpolare und somit hydrophobe Anhydridfunktion hydrophiliert. Ist dem Entwickler, der ein handelsüblicher alkalischer Entwickler sein kann, zum Beispiel ein Amin beigemischt, welches noch einen Wasserstoff am Stickstoffatom tragen muß, wird gemäß

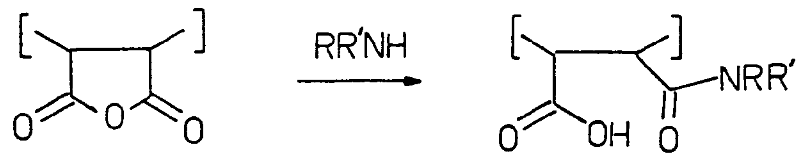


die unpolare und somit hydrophobe Anhydridfunktion in eine stark polare und somit hydrophile Amidocarbonsäure überführt. Wird in dem Verfahren ein positiv arbeitender Photoresist eingesetzt, bei dem die photoaktive Komponente durch photochemische Reaktion einen Polaritätswechsel hin zu einer Löslichkeit im Alkalischen erfährt, so beruht das Entwicklungsverfahren auf dem Prinzip der selektiven Diffusion. Gegenüber dem bekannten Lösungsinhibitorprinzip besteht der Unterschied darin, daß die umgewandelte und somit hydrophile PAC eine Diffusion des Entwicklers in die belichteten Bereiche erlaubt und dort eine Hydrolyse der Anhydridfunktion möglich macht. Zwischen belichteten und unbelichteten Bereichen exisitiert ein Polaritätsunterschied, der nicht nur auf die "zersetzte" photoaktive Komponente zurückzuführen ist, sondern auch im Basispolymer selbst begründet ist durch Umwandlung der Anhydridfunktion. Somit wird gegenüber dem Lösungsinhibitorprinzip ein verbesserter Kontrast bei der Entwicklung erreicht.

Ein erfindungsgemäß einsetzbarer anhydridhaltiger Resist kann ein Polymer, Copolymer oder Terpolymer von anhydridtragenden Monomeren sein. Bei einem gemischten Polymer sind die anderen Monomere frei wählbar mit der Maßgabe, daß die UV-Transparenz des Basispolymeren gewährleistet bleibt. Vorteilhafterweise werden jedoch durch gezielte Auswahl der weiteren Monomere bestimmte gewünschte Eigenschaften im Basispolymer erzeugt. Insbesondere die Ätzresistenz kann zum Beispiel bei Verwendung aromatischer Monomerer gegenüber einem halogenhaltigen Plasma oder bei Verwendung siliziumhaltiger Monomerer gegenüber einem Sauerstoffplasma verstärkt werden. Je nach Anwendung kann das Basispolymer zu 1 bis 99 Prozent von anhydridhaltigen Monomeren abgeleitet sein, vorzugsweise aber zu 10 bis 55 Mol-Prozent.

Wird als Hydrolysereagens ein Amin verwendet, so kann dies sekundär oder primär sein. Auch Ammoniak ist gut geeignet. Bei primären und sekundären Aminen ist der oder die Reste am Stickstoff außer Wasserstoff so ausgewählt, daß das Amin wasserlöslich ist. Dies ist jedoch bei den meisten Aminen mit nicht allzu großen Alkyl-und Arylsubstituenten gewährleistet. Aufgrund einer gewünschten nukleophilen Aktivität des Amins sollten auch keine Elektronen ziehenden Reste an den Substituenten vorhanden sein. Als einfaches und auch gutes Hydrolysereagens wird jedoch Ammoniak gewählt. Die Entwicklerlösung kann das Amin oder Ammoniak in einem Anteil von 0,01 bis 10 Gewichtsprozent enthalten, vorzugsweise jedoch in einem Anteil von 0,1 bis 1,0 Gewichtsprozent. Die Basis der Entwicklerlösung kann ein käuflicher alkalischer Entwickler sein oder eine beliebige andere wäßrig alkalische Lösung, die das hydrophilierte Basispolymer zu lösen vermag.

Die Basispolymere der im erfindungsgemäßen Verfahren eingesetzten Photoresists können cyclische oder lineare Anhydridfunktionen aufweisen. Diese können sowohl in der Haupt- als auch in einer Seitenkette des Basispolymeren enthalten sein. Vorteilhaft wird auch ein Basispolymer eingesetzt, welches ein Kondensationsprodukt von Dicarbonsäuren ist. Dieses weist den Vorteil auf, daß mit- der Hydrolyse der Anhydridfunktion beim Entwicklungsvorgang gleichzeitig auch das Basispolymer hydrolisiert wird.

Gut zugänglich sind Basispolymere, die durch Polymerisation oder Copolymerisation von olefinisch ungesättigten cyclischen Carbonsäureanhydriden erhalten werden. Ein solches Basispolymer kann zum Beispiel der folgenden Struktur A entsprechen,

A 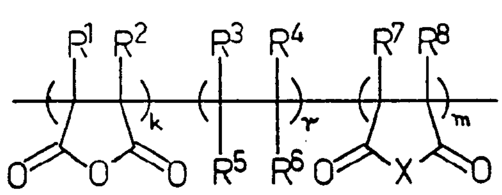

wobei das Strukturfragment mit dem Index k einen Anteil von 10 bis 55 Prozent der gesamten Strukturfragmente k, m und r ausmacht, r oder m gleich O sein kann, $R^1$ bis $R^8$ Wasserstoff, Alkyl, Aryl, Halogen, halogensubstituiertes Alkyl bzw. Aryl oder einen olefinisch ungesättigten Rest bedeuten, $R^3$ außerdem Methoxyphenyl,

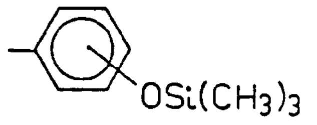 , 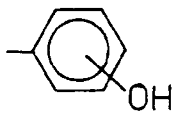 , 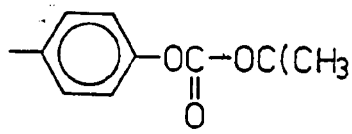 ,

-COOH, -COOR, $-CH_2Si(CH_3)_3$, $-Si(CH_3)_3$, $-Si(OCH_3)_3$

und X = O, NR oder S ist und R für H, Alkyl, Aryl, Vinyl, Allyl oder Acryl steht. Anstelle der mit K indizierten Strukturfragmente kann das Basispolymer auch die den Strukturformeln B,C und D entsprechenden Fragmente als regelmäßig wiederkehrende Struktureinheit aufweisen:

B 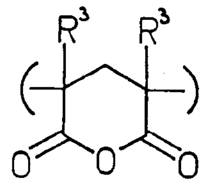 C 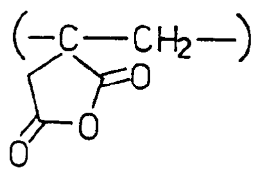 D 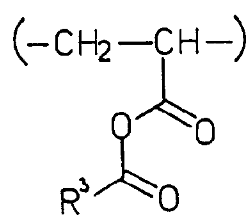

wobei die Reste $R^3$ die angegebenen Bedeutungen annehmen können.

Soll die im erfindungsgemäßen Verfahren erzeugte Photoresiststruktur als Ätzresist in einem halogenhaltigen Plasma dienen, können die zur Copolymerisation mit den anhydridhaltigen Monomeren verwendeten weiteren Monomere den folgenden Vinylaromaten E, F, G und H entsprechen

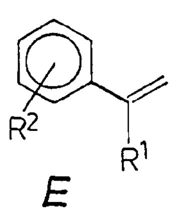 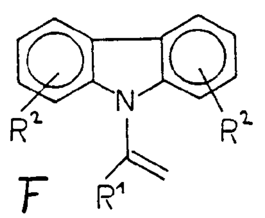 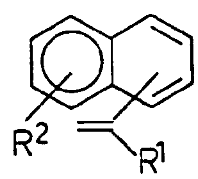 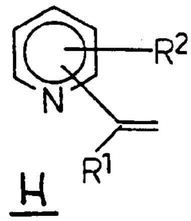

E F G H

wobei $R^1$ und $R^2$ unabhängig voneinander für H, Alkyl, Aryl oder Halogen stehen.

Für positiv arbeitende Photoresists können beliebige photoaktive Komponenten verwendet werden, sofern sie eine der Belichtungswellenlänge angepaßte Schwellenenergie aufweisen. Diese bezeichnet die Energie, die der photoaktiven Komponente bei der Belichtung zugeführt werden muß, um die photochemische Reaktion auszulösen. Im erfindungsgemäßen Verfahren gut verwendbare PAC's sind die bekannten Chinondiazide, die beispielsweise von einer der folgenden Strukturformeln I, K, L oder M abgeleitet sein können:

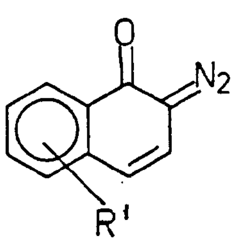 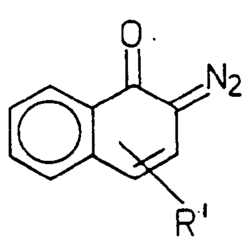 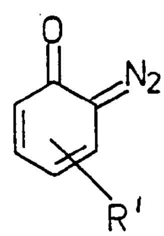 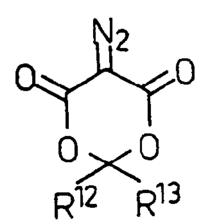

I K L M

wobei $R^{12}$ und $R^{13}$ unabhängig voneinander für einen beliebigen organischen Rest, eine Arylgruppe oder H stehen. R′ kann $-SO_3R$ oder $-CO_2R$ bedeuten, wobei R für Alkyl, Aryl, Halogenalkyl, Halogenaryl oder Halogen

steht. Die von den angegebenen Strukturen abgeleiteten photoaktiven Komponenten sind durch weitere Reste R auf die chemische Struktur des Basispolymeren abgestimmt. Ausgehend zum Beispiel von den mit reaktiven Carbonsäure- bzw. Sulfonsäurederivaten substituierten Chinondiaziden kommen als im Photoresist enthaltene PACs die Umsetzungsprodukte mit aromatischen oder aliphatischen H-aciden Verbindungen wie Alkoholen, Phenolen und Aminen in Frage. Eine besonders geeignete photoaktive Komponente ist der 4- bzw. 5-Sulfonsäureester von Naphthochinondiazid mit mehrwertigen Phenolen wie beispielsweise Bisphenol A oder 2, 3, 4,-Trihydroxybenzophenon.

Der Anteil der im Photoresist enthaltenen PAC ist relativ hoch, da die hydrophilen Eigenschaften der in den belichteten Bereichen einer Photoresistschicht zersetzten PAC auf den gesamten Photoresist übertragen werden und so dessen Eigenschaften bestimmen. Im trocknen und lösungsmittelfreien Photoresist beträgt der Anteil der PAC üblicherweise zwischen 10 und 35 Gewichtsprozent. Dieser Wert variiert naturgemäß mit dem Molgewicht der PAC, liegt aber meist zwischen 15 und 25 Gewichtsprozent.

Neben den angegebenen photoaktiven Komponenten für Positivresists können im erfindungsgemäßen Verfahren auch Photoresists mit negativ arbeitenden PAC's verwendet werden. Als solche sind Radikalbildner oder Bisazide geeignet. Bei dieser grundsätzlich verschiedenen Verfahrensweise wird bei der Belichtung die PAC zwar wie üblich zersetzt, löst aber als Folgereaktion eine Vernetzung des Basispolymeren aus. Im Entwicklungsvorgang kann dieses zwar noch hydrophiliert, aber nicht mehr aufgelöst werden. Vorteilhafterweise werden für Negativresists kürzerkettige Basispolymere verwendet, um die Diffusion des Entwicklers in die unbelichteten Bereiche zu erleichtern. Während das Molgewicht des Basispolymeren bei Positivresists zwischen 1000 und 100000, vorzugsweise jedoch zwischen 1500 und 10000 liegt, wird für Negativresists ein entsprechend niedermolekulares Basispolymer bevorzugt.

Im folgenden wird die Erfindung anhand von fünf Ausführungsbeispielen und sechs dazugehörigen Figuren noch näher erläutert. Es werden drei Photoresistzusammensetzungen und vier Entwicklerlösungen angegeben, deren Verwendung in den Ausführungsbeispielen eine einfache aber vorteilhafte Umsetzung des erfindungsgemäßen Gedankens darstellt.

Die Figuren zeigen dabei verschiedene Verfahrensstufen bei der Herstellung einer Photoresiststruktur auf zwei verschiedenen Substraten anhand schematischer Querschnitte durch die Substrate.

Herstellung der Entwicklerlösung Nr. 1:

1 Gewichtsteil des käuflich erhältlichen Entwicklers AZ 400 K wird mit 5 Gewichtsteilen Wasser verdünnt und mit 0,03 Gewichtsteilen Ammoniak versetzt.

Herstellung der Entwicklerlösung Nr. 2:

1 Gewichtsteil des Entwicklers AZ 400 K wird mit 5 Gewichtsteilen Wasser verdünnt und mit 0,02 Gewichtsteilen n-Butylamin versetzt.

Herstellung der Entwicklerlösung Nr. 3:

1 Gewichtsteil des kommerziell erhältlichen Entwicklers OFPR NMD 3 wird mit 5 Gewichtsteilen Wasser verdünnt und mit 0,03 Gewichtsteilen Ammoniak versetzt.

Herstellung der Entwicklerlösung Nr. 4:

1 Gewichtsteil des Entwicklers AZ 303 wird mit 4 Gewichtsteilen Wasser verdünnt und mit 0,03 Gewichtsteilen Ammoniak versetzt.

Ausführungsbeispiel 1:

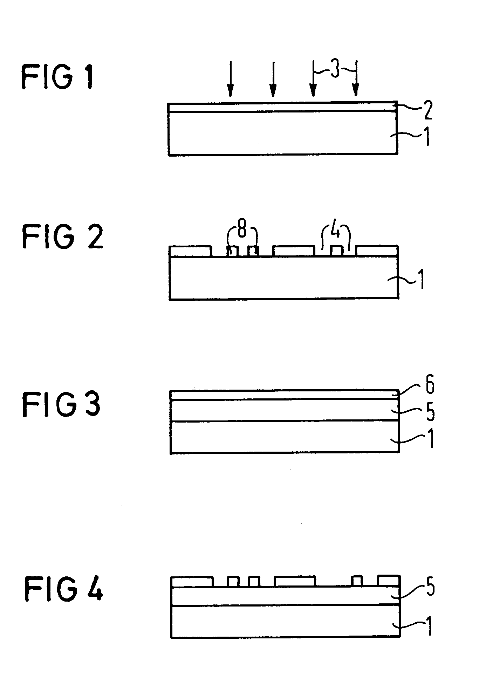

Durch Auflösen von 16 Gewichtsteilen eines alternierenden Copolymers aus Maleinsäureanhydrid und Styrol als Basispolymer und 4 Gewichtsteilen eines Diesters von Bisphenol A mit Naphthochinon-4-sulfonsäure-2-diazid als photoaktive Komponente in 80 Gewichtsteilen (2-Methoxy-1-propyl)-acetat wird eine Photoresistlösung hergestellt. Diese wird unter solchen Bedingungen auf einen 3-Zoll-Siliziumwafer 1 aufgeschleudert, daß nach der Trocknung bei 110°C auf der Hotplate ein Resistfilm 2 mit einer Schichtdicke von 1,0 μm entsteht (siehe Figur 1). Durch eine Maske (in der Figur 1 nicht dargestellt), die Linienstrukturen von 0,5 μm bis 2,0 μm besitzt, wird der so beschichtete Wafer 1 mit einer Dosis von 100 $mJ/cm^2$ bei einer Wellenlänge von 248 nm kontaktbelichtet (siehe Pfeile 3). Der belichtete Wafer 1 wird anschließend 60 Sekunden

lang mit der Entwicklerlösung Nr. 1 entwickelt, mit Wasser gespült und bei 110°C auf der Hotplate getrocknet. Eine Rasterelektronenmikroskopaufnahme zeigt, daß die nach der Entwicklung erhaltenen und in Figur 2 dargestellten Photoresiststrukturen bis 0,5 µm Strukturbreite gut aufgelöst sind. Sowohl Gräben 4 als auch Stege 8 zeigen steile Flankenwinkel. Der Dunkelabtrag unbelichteter Bereiche der Photoresistschicht 2, zum Beispiel auf Stegen 8, liegt bei 3 nm.

Ausführungsbeispiel 2:

Ein wie unter Ausführungsbeispiel 1 beschichteter Wafer 1 wird durch eine Maske, die Linienstrukturen von 0,5 µm bis 2,0 µm besitzt, mit einer Dosis von 80 mJ/cm² bei einer Wellenlänge von 363 nm kontaktbelichtet und anschließend 60 Sekunden mit der Entwicklerlösung Nr. 3 entwickelt. Nach Spülen mit Wasser und Trocknen 110°C auf der Hotplate zeigen Rasterelektronenmikroskopaufnahmen bis 0,5 µm aufgelöste Strukturen mit steilen Flankenwinkeln, sowohl für Gräben 4 als auch für Stege 8. Der Dunkelabtrag unbelichteter Bereiche der Resistschicht 2 liegt bei 3 nm.

Ausführungsbeispiel 3:

Ein wie unter Beispiel 1 beschichteter Wafer 1 wird durch eine Maske mit einer Dosis von 70 mJ/cm² und einer Wellenlänge von 363 nm kontaktbelichtet und anschließend mit der Entwicklerlösung Nr. 2 behandelt. Im Rasterelektronenmikroskop ist zu erkennen, daß die bis 0,5 µm Strukturbreite auf der Maske vor gegebenen Strukturen mit guter Auflösung auf die Photoresiststruktur übertragen wurden und dort Gräben und Stege mit steilen Flankenwinkeln erzeugt haben. Der Dunkelabtrag unbelichteter Bereiche der Photoresistschicht 3 beträgt 5 nm.

Ausführungsbeispiel 4:

Durch Auflösen von 16 Gewichtsteilen eines alternierenden Copolymers aus Maleinsäureanhydrid und Allyltrimethylsilan als Basispolymer und 4 Gewichtsteilen eines Diesters von Bisphenol A mit Naphthochinon-4-sulfonsäure-2-diazid als photoaktive Komponente in 80 Gewichtsteilen (2-Methoxy-1-propyl)-acetat wird eine Photoresistlösung hergestellt. Als Substrat wird ein 3-Zoll-Siliziumwafer 1 verwendet, der mit einer 1,8 µm dicken und bei 210°C vernetzten Schicht 5 des käuflichen Photoresists MP1450J beschichtet ist. Auf dieses Substrat 1 wird die oben hergestellte Photoresistlösung unter solchen Bedingungen aufgeschleudert, daß nach der Trocknung bei 110°C auf der Hotplate ein Resistfilm 6 mit einer Schichtdicke von 1,0 µm entsteht (siehe Figur 3). Mit der bereits beschriebenen Maske wird der Wafer nun mit einer Dosis von 100 mJ/cm² bei einer Wellenlänge von 248 nm kontaktbelichtet. Mit der Entwicklerlösung Nr. 1 wird 75 Sekunden lang behandelt, anschließend mit Wasser gespült und bei 110°C auf der Hotplate getrocknet. Die Röntgenelektronenmikroskopaufnahmen zeigen ebenfalls sehr gut bis 0,5 µm aufgelöste Strukturen in der oberen Resistschicht 6, die steile Flankenwinkel aufweisen und in Figur 4 dargestellt sind. Ein Dunkelabtrag ist nicht festzustellen.

Ausführungsbeispiel 5:

Ein 3-Zoll-Siliziumwafer 1 wird mit dem käuflichen Photoresist MP13503 so beschichtet, daß nach Trocknung bzw. Vernetzung bei 220°C eine Resistschicht 5 mit einer Schichtdicke von 1,8 µm erhalten wird. Durch Auflösen von 4 Gewichtsteilen eines alternierenden Copolymers aus Maleinsäureanhydrid und Allyltrimethylsilan sowie 12 Gewichtsteilen eines Copolymers aus Vinyltrimethylsilan und Vinylphenol als Basispolymere und 4 Gewichtsteilen eines Diesters von Bisphenol A mit Naphthochinon-4-sulfonsäure-2-diazid als photoaktive Komponente in 80 Gewichtsteilen (2-Methoxy-1-propyl)-acetat wird eine Photoresistlösung hergestellt. Diese wird unter solchen Bedingungen auf die vorher erzeugte Resistschicht 5 aufgeschleudert, daß nach der Trocknung bei 110°C auf der Hotplate ein Resistfilm 6 mit einer Schichtdicke von 1,0 µm entsteht. Mit einer Graukeilmaske (Ditric Optics Inc.) wird der so beschichtete Wafer mit einer Dosis von 120 mJ/cm² bei 248 nm belichtet. Anschließend wird 60 Sekunden lang im Tauchbad mit dar Entwicklerlösung Nr. 4 entwickelt. Der Kontrast der im Resistfilm 6 erzeugten Strukturen wird mit $\gamma$ = 2,8 bestimmt. Kontrollversuch:

Zum Vergleich und Test der im erfindungsgemäßen Verfahren eingesetzten Entwicklerlösungen wird das Ausführungsbeispiel 5 mit dem Unterschied wiederholt, daß anstelle der Entwicklerlösung Nr. 4 der käufliche Entwickler AZ 303 in der vierfachen Menge Wasser verdünnt im Tauchbad zur Entwicklung eingesetzt wird. In diesem Fall wird lediglich ein Kontrast $\gamma$ von 1,5 für die verschiedenen Graustufen der Maske gemessen. Dieser Unterschied zeigt deutlich die Vorteile des erfindungsgemäß eingesetzten ammoniak- oder aminhaltigen Entwicklers.

## Patentansprüche

1. Verfahren zum Erzeugen einer kontrastreichen Photoresiststruktur im sub-µm-Bereich mit steilen Flanken, bei dem
   a) auf ein Substrat eine Photoresistschicht aufgebracht und gegebenenfalls getrocknet und vorvernetzt wird, wobei der Photoresist eine photoaktive Komponente und ein Basispolymer enthält, das als entwickelbare funktionelle Gruppen Anhydridfunktionen aufweist,
   b) die Photoresistschicht über eine Maske dergestalt strukturierend belichtet wird, daß in den belichteten Bereichen eine chemische Veränderung der photoaktiven Komponente erzielt wird, und
   c) die strukturierend belichtete Photoresistschicht mit einer wäßrig-alkalischen Entwicklerlösung behandelt wird, wobei diese Entwicklerlösung ein Amin enthält, welches zumindest ein aktives, an den Stickstoff gebundenes Wasserstoffatom aufweist, und welches die Anhydridgruppen der Photoresistschicht in bestimmten, von der Belichtung abhängigen Bereichen zu hydrolisieren vermag.

2. Verfahren nach Anspruch 1,
   **dadurch gekennnzeichnet,**
   daß die verwendete Entwicklerlösung ein Amin in einem Anteil von 0,01 bis 10 Gewichtsprozent enthält.

3. Verfahren nach Anspruch 2,
   **dadurch gekennzeichnet,**
   daß das Amin in der Entwicklerlösung in einem Anteil von 0,1 bis 1,0 Gewichtsprozent enthalten ist.

4. Verfahren nach mindestens einem der Ansprüche 1 bis 3,
   **dadurch gekennzeichnet,**
   daß als Reagens ein primäres Alkylamin mit 1 bis 10 C-Atomen verwendet wird.

5. Verfahren nach mindestens einem der Ansprüche 1 bis 3,
   **dadurch gekennzeichnet,**
   daß als Reagens alternativ Ammoniak verwendet wird.

6. Verfahren nach mindestens einem der Ansprüche 1 bis 3,
   **dadurch gekennzeichnet,**
   daß das als Reagens verwendete Amin eine weitere lösungsvermittelnde Gruppe trägt.

7. Verfahren nach Anspruch 6,
   **dadurch gekennzeichnet,**
   daß das Reagens ausgewählt ist aus der Gruppe der Aminoalkohole, Aminocarbonsäuren und Aminosulfonsäuresalze.

8. Verfahren nach Anspruch 1,
   **dadurch gekennzeichnet,**
   daß beim Verfahrensschritt c) die strukturierend belichtete Photoresistschicht zunächst mit einem Amin behandelt wird und anschließend in an sich bekannter Weise mit einem alkalischen Entwickler entwickelt wird.

## Claims

1. Method of producing a high-contrast photoresist pattern in the sub-µm range with steep edges, in which
   a) a photoresist layer is applied to a substrate, and optionally dried and precured, the photoresist containing a photoactive component and a base polymer which has anhydride functions as developable functional groups,
   b) the photoresist layer is patterned by exposure via a mask in such a way that a chemical alteration in the photoactive component is achieved in the exposed areas, and
   c) the photoresist layer patterned by exposure is treated with an aqueous alkaline developer solution, said developer solution containing an amine which has at least one active hydrogen atom bonded to the nitrogen and which is capable of hydrolysing the anhydride groups of the photoresist layer in certain areas which depend on the exposure.

2. Method according to Claim 1, characterized in that the developer solution used contains an amine in a proportion of 0.01 to 10 per cent by weight.

3. Method according to Claim 2, characterized in that the amine is contained in the developer solution in a proportion of 0.1 to 1.0 per cent by weight.

4. Method according to at least one of Claims 1 to 3, characterized in that a primary alkylamine containing 1 to 10 carbon atoms is used as reagent.

5. Method according to at least one of Claims 1 to 3, characterized in that ammonia is alternately used as reagent.

6. Method according to at least one of Claims 1 to 3, characterized in that the amine used as reagent carries a further solubilizing group.

7. Method according to Claim 6, characterized in that the reagent is selected from the group comprising the aminoalcohols, aminocarboxylic acids and aminosulphonic acid salts.

8. Method according to Claim 1, characterized in that, in method step c), the photoresist layer patterned by exposure is first treated with an amine and is then developed in a manner known per se with an alkaline developer.

## Revendications

1. Procédé pour fabriquer une structure de résine photosensible à contraste élevé, d'une taille inférieure au micron et comportant des flancs pentus, selon lequel
   a) sur un substrat, on dépose une couche de résine photosensible et éventuellement on la fait sécher et on la fait préréticuler, la résine photosensible étant un constituant actif du point de vue photochimique et contenant un polymère de base, qui possède des fonctions anhydride en tant que groupes fonctionnels développables,
   b) on expose, de manière à la structurer, une couche de résine photosensible moyennant l'interposition d'un masque de manière à obtenir une modification chimique du constituant actif du point de vue photochimique, dans les zones exposées, et
   c) on traite la couche de résine photosensible, qui est exposée en vue de sa structuration, avec une solution de développement aqueuse-alcaline, cette solution de développement contenant une amine qui possède au moins un atome d'hydrogène actif lié à l'azote et qui peut hydrolyser les groupes anhydride de la couche de résine photosensible dans des zones déterminées, qui dépendent de l'exposition.

2. Procédé suivant la revendication 1, caractérisé par le fait que la solution de développement utilisée contient une amine en un pourcentage compris entre 0,01 et 10 pour cent en poids.

3. Procédé suivant la revendication 2, caractérisé par le fait que l'amine est présente dans la solution de développement en un pourcentage compris entre 0,1 et 1,0 pour cent en poids.

4. Procédé suivant au moins l'une des revendications 1 à 3, caractérisé par le fait qu'on utilise comme réactif une alkylamine primaire contenant 1 à 10 atomes de C.

5. Procédé suivant au moins l'une des revendications 1 à 3, caractérisé par le fait qu'on utilise par ailleurs de l'ammoniac comme réactif.

6. Procédé suivant au moins l'une des revendications 1 à 3, caractérisé par le fait que l'amine utilisé comme réactif comporte un autre groupe provoquant la solubilisation.

7. Procédé suivant la revendication 6, caractérisé par le fait que le réactif est choisi dans le groupe des amino-alcools, des acides amino-carboniques et des sels d'acides amino-sulfoniques.

8. Procédé suivant la revendication 1, caractérisé par le fait que lors de l'étape opératoire c), on traite la couche de résine photosensible, exposée en vue de sa structuration, tout d'abord avec une amine et qu'on la développe ensuite de façon connue en soi à l'aide d'un agent de développement alcalin.

FIG 1

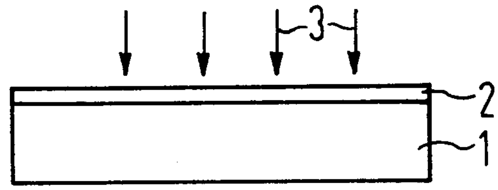


FIG 2

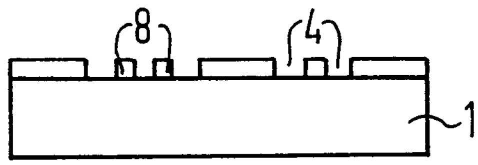


FIG 3

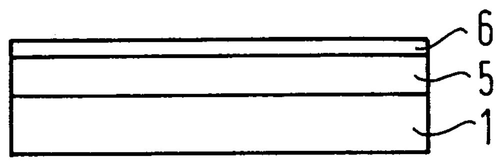


FIG 4